# EUROPEAN PATENT APPLICATION

(11) **EP 4 586 755 A1**
(43) Date of publication of application: **16.07.2025**
(21) Application number: 23862844.0
(22) Date of filing: 03.08.2023
(51) Int. Cl.: H05K 9/00, G04G 17/04

(54) **MODULE AND ELECTRONIC APPARATUS**

(30) Priority: 07.09.2022 JP 2022142205
(71) Applicant: CASIO COMPUTER CO., LTD., Tokyo 151-8543 (JP)
(72) Inventor: SAWAI, Masashi, Hamura-shi, Tokyo 205-8555 (JP)
(74) Representative: Grünecker Patent- und Rechtsanwälte PartG mbB
(86) International application number: PCT/JP2023/028469
(87) International publication number: WO 2024/053301

(57) **Abstract**

It is possible to stably hold a display inside a device without adhesively fixing the display. A module as a holding structure of a display unit 4 which is a display includes: the display unit 4 which is the display having a flat plate shape; a circuit board 6 disposed below the display unit 4 to overlap the display unit 4, and equipped with a shield member 7 that covers a circuit element 61 on a surface facing the display unit 4; and a buffer member 8 that is disposed on an upper surface of the shield member 7 and abuts on a lower surface of the display unit 4.

## Description

### TECHNICAL FIELD

The present invention relates to a module and an electronic device.

### BACKGROUND ART

Conventionally, a wearable device (an electronic device such as an electronic watch) including a display ("LCD" in Patent Literature 1) including a display panel and the like inside a device case has been known (see, for example, Patent Literature 1.)**.**

As described in Patent Literature 1, in a case where a device includes a display (LCD), the display (LCD) is, for example, adhesively fixed to a member (windshield member, "cover glass" in Patent Literature 1) that covers a device surface. Thus, the display (LCD) is supported so as not to be movable.

### CITATION LIST

### PATENT LITERATURE

Patent Literature 1: JP 2013-134925 A

### SUMMARY OF THE INVENTION

### TECHNICAL PROBLEM

However, if the display (LCD) is fixed by adhesion or the like to the windshield member (cover glass) or the like, when some defect occurs in the display (LCD), only the display (LCD) cannot be removed and repaired or replaced.

It is therefore necessary to replace many components including the windshield member (cover glass) to which the display (LCD) is fixed together or to replace the device itself.

The present invention is intended to solve such problems, and an object of the present invention is to provide a module and an electronic device capable of stably holding a display inside a device without adhesively fixing the display.

### SOLUTION TO PROBLEM

In order to solve the problem, a module according to the present invention is characterized as including a display having a flat plate shape; a circuit board disposed below the display to overlap the display, and equipped with a shield member that covers a circuit element on a surface facing the display; and a buffer member that is disposed on an upper surface of the shield member and abuts on a lower surface of the display.

### ADVANTAGEOUS EFFECTS OF INVENTION

According to the present invention, it is possible to stably hold a display inside a device without adhesively fixing the display.

### BRIEF DESCRIPTION OF THE DRAWINGS

Fig. 1 is a front view of a main part of a watch according to an embodiment.
Fig. 2 is a sectional view of the watch taken along line II-II in Fig. 1.
Fig. 3 is a perspective view of a main part illustrating an assembled state of a bezel, a windshield member, and a display unit according to the embodiment.
Fig. 4 is an exploded perspective view of main parts of the bezel, the windshield member, and the display unit according to the embodiment.
Fig. 5 is an exploded perspective view of main parts of the windshield member and the display unit illustrated in Fig. 4.
Fig. 6 is a perspective view of a circuit board and a shield member disposed on the circuit board according to the embodiment.
Fig. 7 is an enlarged sectional view of a main part of a portion VII surrounded by a broken line in Fig. 6.
Fig. 8 is a perspective view of the circuit board in which the shield member is disposed on an upper surface in the embodiment.
Fig. 9 is an enlarged sectional view of a main part of a portion IX surrounded by a broken line in Fig. 8.
Fig. 10 is a plan view of the circuit board according to the embodiment as viewed from a viewing side.
Fig. 11 is a plan view of a modification of the circuit board in the embodiment as viewed from the viewing side.
Fig. 12 is a front view of a main part of a watch according to a modification.

### DESCRIPTION OF EMBODIMENTS

An embodiment of a module of the present invention and an electronic device including the module will be described with reference to the drawings. In the present embodiment, a case where the electronic device is an electronic watch worn on an arm of a user will be described as an example.

Note that although various technically preferable limitations are given to the embodiment described below in order to carry out the present invention, the scope of the present invention is not limited to the following embodiment and illustrated examples.

### [Configuration]

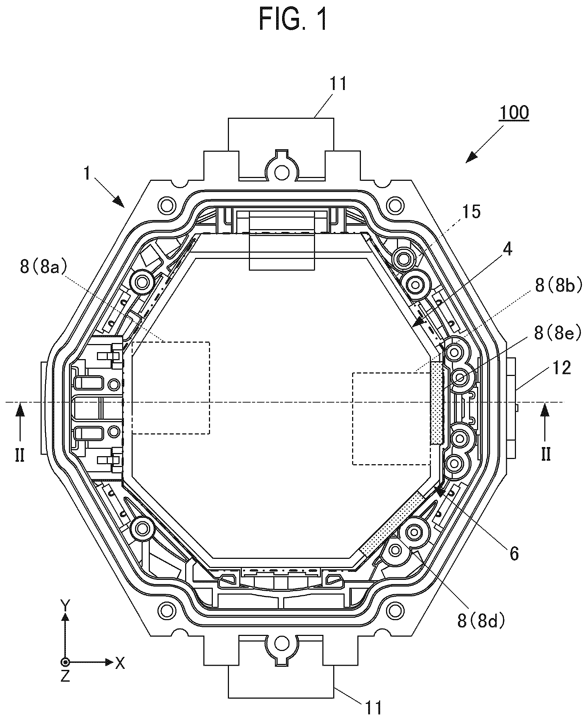

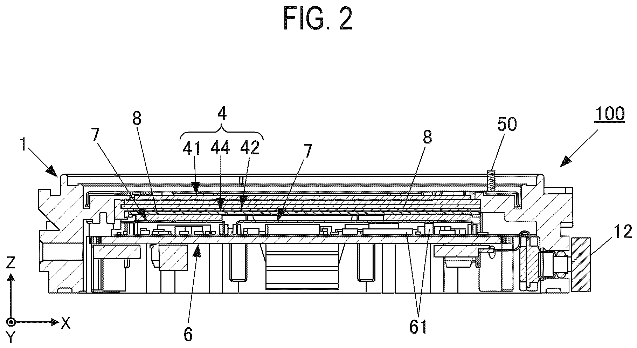

Fig. 1 is a plan view illustrating an internal main configuration of an electronic watch (hereinafter, simply referred to as a "watch") according to the present embodiment, and Fig. 2 is a sectional view of the watch illustrated in Fig. 1.

As illustrated in Figs. 1 and 2, a watch 100 according to the present embodiment includes a device case 1.

The device case 1 according to the present embodiment has a hollow short column shape with upper and lower openings, and a hollow portion inside constitutes a storage space for storing various components.

The device case 1 includes a relatively hard synthetic resin such as engineering plastic or super engineering plastic, for example. Note that the material forming the device case 1 is not limited to the material exemplified here. The device case 1 may include a metal material such as SUS.

A pair of band attachment portions 11 (see Fig. 1) to which a band (not illustrated) is attached is provided at upper and lower positions (a twelve o'clock position and a six o'clock position in an analog clock) in Fig. 2 on an outer side surface of the device case 1.

Various operation buttons 12 (push buttons, screens, and the like) for a user to perform various input operations are provided on the left, right, and the like of the device case 1 in Fig. 2.

Although not illustrated, an opening on a back surface side (non-viewing side of the watch) of the device case 1 is closed by a back lid member (not illustrated). The back lid member may be formed integrally with the device case 1.

As illustrated in Fig. 2, a coil spring 50 that connects a solar panel (not illustrated) and a circuit board 6 is provided.

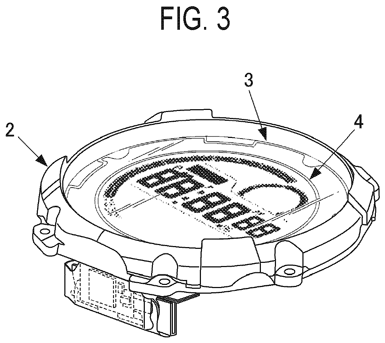

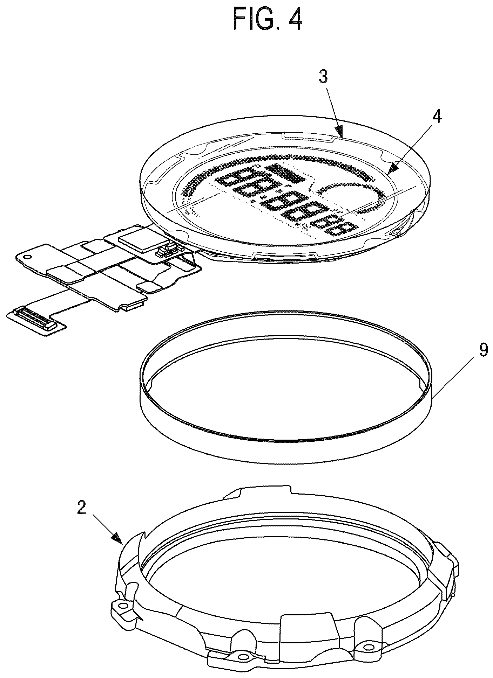

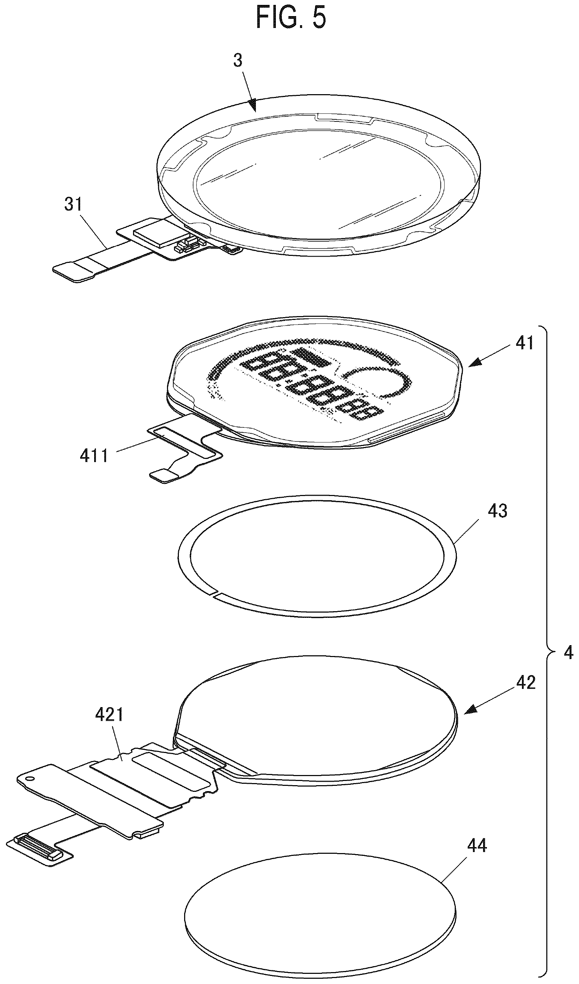

Fig. 3 is an exploded perspective view illustrating a bezel, a windshield member, and a display unit provided on a front surface side (a viewing side of the watch) of the device case. Fig. 4 is an exploded perspective view of the bezel, the windshield member, and the display unit illustrated in Fig. 3. Fig. 5 is an exploded perspective view of the windshield member and the display unit. Figs. 1 and 2 illustrate a state in which a bezel 2 and a windshield member 3 are removed for easy viewing of an internal configuration. The bezel 2 and the windshield member 3 illustrated in Fig. 3 are disposed, for example, on the device case 1 illustrated in Fig. 2 (on an upper side in Fig. 2, an upper side of the display unit 4, and the viewing side).

The bezel 2 as an exterior member is provided on the front surface side (viewing side of the watch) of the device case 1 so as to surround the opening. The bezel 2 is fixed to the device case 1 with, for example, screws (not illustrated).

As illustrated in Figs. 3 and 4, the bezel 2 is a member having a substantially annular shape when the watch 100 is viewed from the viewing side. The bezel 2 includes, for example, various resin materials. The material forming the bezel 2 is not limited.

The opening on the front surface side (viewing side of the watch) of the device case 1 is closed by the windshield member 3. The windshield member 3 is a transparent member including, for example, a glass material, a transparent resin material, or the like. The windshield member 3 is attached to the device case 1 or the bezel 2 attached to the device case 1 with a windshield gasket 9 or the like interposed therebetween. By attaching the windshield member 3 to the device case 1 or the bezel 2 with the windshield gasket interposed therebetween, it is possible to close the opening on the front surface side (viewing side of the watch) of the device case 1 while securing a waterproof property (airtightness) of the inside of the device case 1.

A touch panel is integrally formed with the windshield member 3 according to the present embodiment, and as illustrated in Figs. 4 and 5, a flexible printed wiring board (hereinafter referred to as "FPC 31") is connected to the windshield member 3. Another end side of the FPC 31 is electrically connected to the circuit board 6 to be described later, and can function as a touch panel by reading a touch operation by the user or the like. It is not essential that the touch panel is integrally formed with the windshield member 3. The windshield member 3 may be only a plate member such as glass. In this case, the FPC31 is not required to be provided.

Furthermore, the display unit 4 as a display is provided below the windshield member 3 (on the non-viewing side).

As illustrated in Fig. 5 and the like, the display unit 4 is a flat plate-shaped display, and includes a liquid crystal display panel 41, a light guide plate 42, a reflection plate 44 (reflection member), and the like. The liquid crystal display panel 41 and the light guide plate 42 are bonded and fixed to each other by, for example, a double-sided tape 43 to be integrated.

The display panel of the display unit 4 is not limited to the liquid crystal display panel, and may be, for example, an organic electroluminescence display or another flat display.

The liquid crystal display panel 41 has, for example, the following configuration. That is, a pair of transparent electrodes (not illustrated) is provided on each opposing surface of the pair of upper and lower transparent substrates, and a liquid crystal (not illustrated) is sealed between the pair of transparent substrates. A stacked structure is formed in which an upper polarizing plate is provided on an upper surface of the upper transparent substrate and a lower polarizing plate is provided on a lower surface of the lower transparent substrate.

The light guide plate 42 guides light from a light source (LED or the like) (not illustrated) provided in the device case 1 to the liquid crystal display panel 41.

A flexible printed wiring board (hereinafter referred to as "FPC 411") is connected to the liquid crystal display panel 41, and a flexible printed wiring board (hereinafter referred to as "FPC 421") is connected to the light guide plate 42. Another end side of each of the FPC 411 and the FPC 421 is electrically connected to the circuit board 6 to be described later, and is appropriately controlled.

That is, the display unit 4 guides the light from the light source to the liquid crystal display panel 41 by the light guide plate 42, selectively applies a voltage to the pair of transparent electrodes (not illustrated) to change an alignment state of the liquid crystal (not illustrated) of the liquid crystal display panel 41, and controls a light transmission state by the liquid crystal. Thus, the display unit 4 is configured to appropriately display information such as time according to the control.

The FPC 31 connected to the touch panel of the windshield member 3, the FPC 411 connected to the liquid crystal display panel 41 of the display unit 4, and the FPC 421 connected to the light guide plate 42 are overlapped and integrated into one. When the bezel 2, the windshield member 3, and the display unit 4 are assembled to the device case 1, for example, as illustrated in Fig. 3, the bezel 2, the windshield member 3, and the display unit 4 are folded into such a shape and size to be easily accommodated in the device case 1.

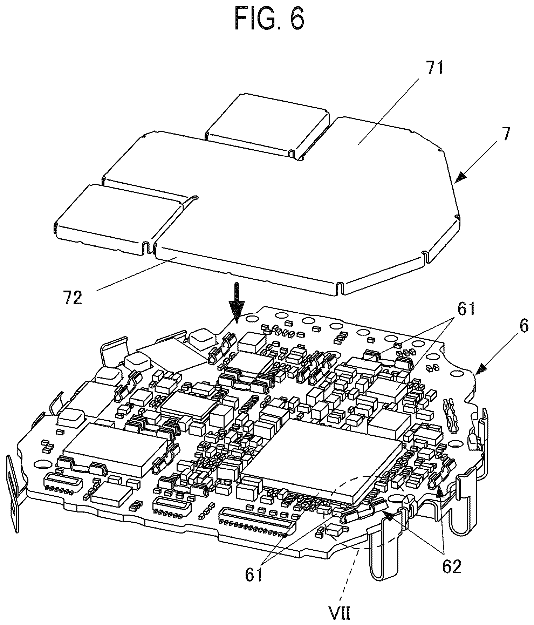

In the device case 1, the circuit board 6 is disposed below (below in Fig. 2 and on the non-viewing side of) the display unit 4 so as to overlap the display unit 4. In the present embodiment, the shield member 7 is disposed on an upper surface of the circuit board 6 (that is, a surface on a side facing the display unit 4). Fig. 6 is a perspective view of the circuit board and the shield member disposed on the circuit board according to the present embodiment. In Fig. 6, a thick arrow indicates a direction in which the shield member 7 is attached to the circuit board 6.

As illustrated in Fig. 6 and the like, various circuit elements 61 which are elements constituting an electric circuit are mounted on at least the upper surface of the circuit board 6. The shield member 7 covering at least a part of the circuit elements 61 is placed on the circuit board 6. The circuit element 61 covered with the shield member 7 is protected from external impact and the like.

As illustrated in Fig. 6 and the like, the shield member 7 includes a flat plate-shaped upper surface portion 71 and a side surface portion 72 suspended from an edge of the upper surface portion 71. The shield member 7 has a substantially box shape with a sheet metal such as SUS. Note that the material, shape, and the like of the shield member 7 are not limited to those exemplified here.

One or more board clips 62 are provided on the circuit board 6 at a portion where the side surface portion 72 of the shield member 7 is disposed. The board clip 62 includes a metal material, and is a holder fixed onto the circuit board 6 by means such as soldering. Note that a method of fixing the board clip 62 onto the circuit board 6 is not limited to soldering, and various methods can be applied. At which position and how many board clips 62 are disposed on one shield member 7 is appropriately determined in accordance with the position of the circuit element 61 and a mounting situation of each member.

The shield member 7 is in contact with the circuit board 6 serving as a ground (GND) on a side surface (indirectly with the metal board clip 62 interposed therebetween), and has the same potential as the ground.

The display unit 4 and the buffer member 8 are fixed by being sandwiched between the circuit board 6 including the shield member 7 and the device case 1 (in particular, an inward flange or the like protruding inward at the opening of the device case 1) which is a fixing member. In this manner, the position in a height direction (Z direction) in the sectional view illustrated in Fig. 2 is regulated by being sandwiched with the buffer member 8 interposed therebetween.

As illustrated in Fig. 1, the device case 1 as a fixing member is provided with a wall 15 that is larger than the display unit 4, has the same shape as the display unit 4, and is indicated by a one-dot chain line.

In the present embodiment, the display unit 4 and the wall 15 of the device case 1 are substantially octagonal in a front view of the device case 1 (see Fig. 1). The buffer member 8 (8d and 8e) is disposed in a gap between a portion positioned at two sides of an outer peripheral surface of the substantially octagonal display unit 4 and the wall 15 of an inner peripheral surface of the device case 1.

As a result, by the two buffer members 8 (8d and 8e) disposed on different surfaces in a lateral direction (X direction) and a depth direction (Y direction) in the sectional view illustrated in Fig. 2, the display unit 4 is pressed against and fixed to the wall 15 of the inner peripheral surface of the device case 1 facing the different surfaces. As illustrated in Fig. 1, in the present embodiment, the two buffer members 8 (8d and 8e) are disposed on the outer peripheral surfaces adjacent to each other among the eight outer peripheral surfaces of the octagonal display unit **4.**

The arrangement positions of the two buffer members 8 (8d and 8e) are not limited to the above. For example, the buffer member 8d may be disposed on one of both adjacent outer peripheral surfaces across one outer peripheral surface of the octagonal display unit 4 in the front view (plan view) of Fig. 1 corresponding to the lateral direction (X direction) and the depth direction (Y direction) in the sectional view of Fig. 2, and the buffer member 8e may be disposed on the other one of both adjacent outer peripheral surfaces. With such an arrangement, a line connecting the wall 15 of the inner peripheral surface of the device case 1 and the opposing wall 15 at a portion where the buffer member 8d is disposed is orthogonal to a line connecting the wall 15 of the inner peripheral surface of the device case 1 and the opposing wall 15 at a portion where the buffer member 8e is disposed. Therefore, the display unit 4 can be more stably pressed against and fixed to the wall 15 of the inner peripheral surface of the device case 1.

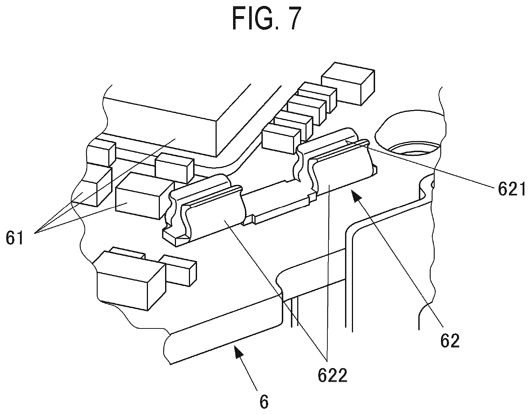

Fig. 7 is an enlarged sectional view of a main part of a portion VII surrounded by a broken line in Fig. 6.

As illustrated in Fig. 7, the board clip 62 includes a holder 622 having a gap 621 corresponding to a thickness of the side surface portion 72 of the shield member 7.

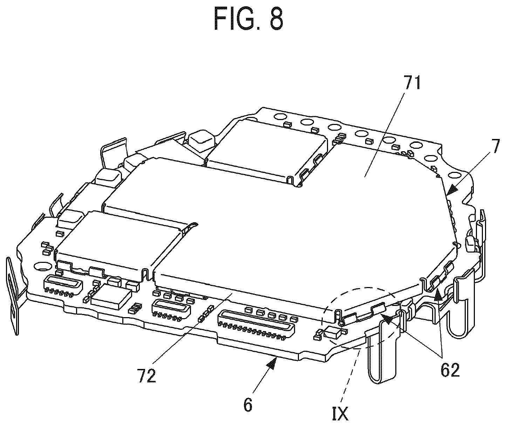

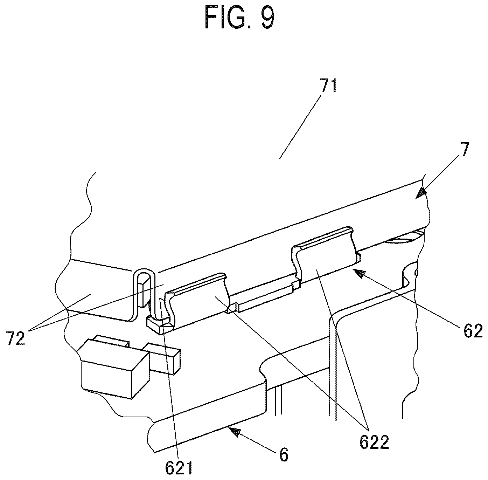

Fig. 8 is a perspective view of the circuit board in which the shield member is disposed on the upper surface in the embodiment, and Fig. 9 is an enlarged sectional view of a main part of a portion IX surrounded by a broken line in Fig. 8.

As illustrated in Figs. 8 and 9, by fitting the side surface portion 72 of the shield member 7 into the gap 621 of the holder 622, the shield member 7 (the side surface portion 72 of the shield member 7) is held by the board clip 62 and locked onto the circuit board 6.

The holder 622 of the board clip 62 can slightly bend like a leaf spring, and may be configured to hold (grip) the side surface portion 72 fitted in the gap 621, or may simply receive the side surface portion 72 in the gap 621.

In either case, unlike a case where the shield member 7 is directly fixed onto the circuit board 6 by soldering or the like, the shield member 7 can also be removed after being fitted into the holder 622 of the board clip 62. By fixing the shield member 7 to the circuit board 6 with the board clip 62 interposed therebetween in this manner, in a case where a defect or the like occurs in a part of the circuit element 61 on the circuit board 6 covered with the shield member 7, the shield member 7 can be removed, and the internal circuit element 61 can be repaired, replaced, or the like.

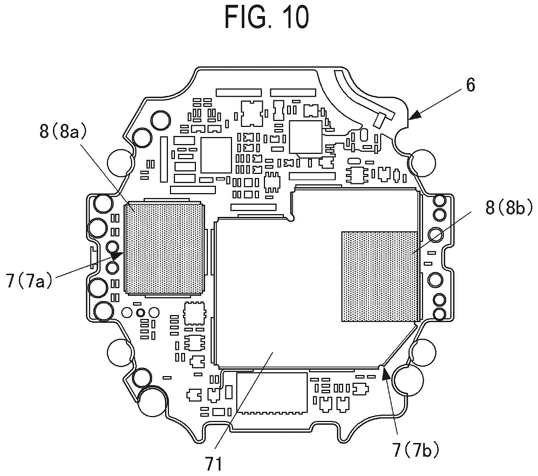

The shape, number, height, and the like of the shield member 7 are not limited to the illustrated examples. In Figs. 6 and 8, a case has been exemplified where one shield member 7 formed in series is disposed on the circuit board 6, but the shield member 7 may be divided into a plurality of parts as in Fig. 10, for example.

Fig. 10 is a plan view of the circuit board including the shield member as viewed from the viewing side. The example illustrated in Fig. 10 illustrates a case where two large and small shield members 7 (in Fig. 10, a small shield member is denoted by 7a, and a large shield member is denoted by 7b) are disposed on the circuit board 6. In a case where a plurality of shield members 7 is provided on the circuit board 6 as illustrated in Fig. 10, the heights (dimensions in a case thickness direction) of all the shield members 7 are preferably aligned.

The reflection plate 44 (reflection member) is provided under the light guide plate 42 of the display unit 4. Therefore, the buffer member 8 and the shield member 7 located under the light guide plate 42 with the reflection plate 44 (reflection member) interposed therebetween are not visually recognized by the user.

The buffer member (cushion material) 8 is disposed on the upper surface (upper surface portion 71) of the shield member 7. In Fig. 10, the buffer member 8 is indicated by gray shading. In Fig. 10, the buffer member 8 disposed on the shield member 7a is referred to as a buffer member 8a, and the buffer member 8 disposed on the shield member 7b is referred to as a buffer member 8b.

The buffer member 8 is disposed on the upper surface portion 71 of the shield member 7 and is in contact with a lower surface of the display unit 4 as a display (see Fig. 2). The buffer member 8 includes various resins or the like having excellent impact absorbability and being expected to have an anti-slip effect. As a material of the buffer member 8, for example, a highly functional urethane foam such as a microcell polymer sheet (for example, "PORON" (registered trademark) manufactured by Rogers Inoac Corporation) is suitably used. The material forming the buffer member 8 is not limited to this material.

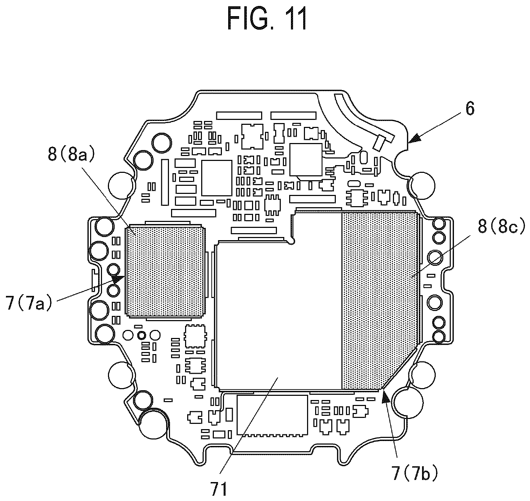

The buffer member 8 is in surface contact with the lower surface of the display unit 4 and the upper surface of the shield member 7. The shape, size, and the like of the buffer members 8 (8a and 8b) are not limited, but the buffer members 8 preferably have a certain area so that a pressure can be dispersed as uniformly as possible. For example, as illustrated in Fig. 10, in a case where two large and small shield members 7 (7a and 7b) are provided, the buffer member 8a is disposed on the entire upper surface of the small shield member 7a on the left side in Fig. 10. In the large shield member 7b, the buffer member 8b is disposed at such a position on an outer peripheral edge of the shield member 7b as to be substantially symmetrical to the buffer member 8a disposed on the small shield member 7a about an in-plane center of the circuit board 6. As illustrated in Figs. 10 and 11, in a case where a plurality of shield members 7 (7a and 7b) is provided, the buffer member 8 (8a, 8b, or 8c) is provided corresponding to each of the plurality of shield members 7 (7a and 7b).

The arrangement position of the buffer member 8 is not limited, but in the present embodiment, as illustrated in Fig. 1, the buffer member 8 is disposed on an outer peripheral side of the display unit 4. The plurality of buffer members 8 is preferably disposed at or near symmetrical positions while avoiding a central portion of the display unit 4. By arranging the buffer members 8 substantially symmetrically on the outer peripheral side of the display unit 4, it is possible to avoid pressure from being concentrated only on a part.

The buffer member 8a and the buffer member 8b preferably have the same shape. In a case where a plurality of the buffer members 8 is provided, by using the buffer members 8 having the same shape, it is possible to cope with the buffer members 8 with common components and to suppress manufacturing cost.

In a case where the plurality of shield members 7 (dimensions in the case thickness direction) is not uniform and varies, it is preferable to adjust the heights by adjusting the thickness of the buffer member 8 provided on the upper surface of each shield member 7. In this manner, the display unit 4 can be received by a substantially flat surface without rattling.

In a case where the shield member 7 is integrated as illustrated in Figs. 6 and 8, the plurality of buffer members 8 is also preferably disposed at or near the symmetrical positions while avoiding the central portion of the display unit 4.

In a case where the plurality of buffer members 8 is provided, the plurality of buffer members 8 is not required to have the same shape and size.

For example, as illustrated in Fig. 11, the buffer member 8c provided on the upper surface portion 71 of the large shield member 7b may have a larger area than the buffer member 8a disposed on the small shield member 7a. In this case, the buffer member 8c is also preferably disposed at such a position on the outer peripheral edge of the shield member 7b as to avoid the central portion of the display unit 4 disposed to overlap the circuit board 6 and be substantially symmetrical to the buffer member 8a disposed on the shield member 7a about the in-plane center of the circuit board 6.

Note that the shapes of the device case 1 and the display unit 4 are not limited to those illustrated in the present embodiment.

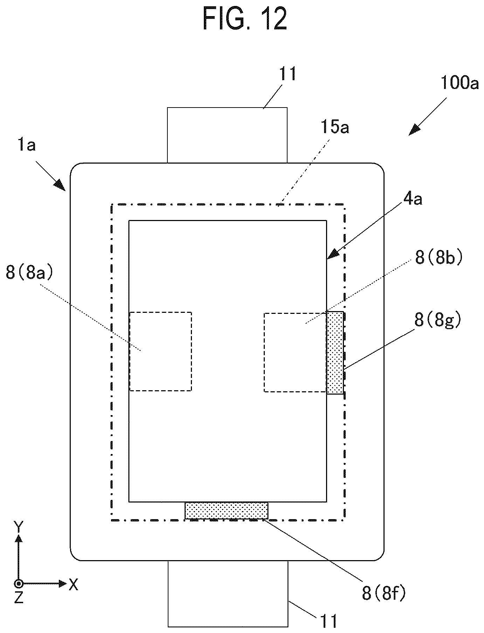

Fig. 12 illustrates a modification of the watch in which the shapes of the device case and the display unit are different.

For example, as schematically illustrated in Fig. 12, the external shapes of a device case 1a and a display unit 4a may be both rectangular or the like in a front view the device case 1a of a watch 100a.

In a case where the external shapes of the device case 1a and the display unit 4a are rectangular, for example, the buffer members 8 (8f and 8g) are disposed in a gap between two sides adjacent to each other of outer peripheral sides of the display unit 4a and a portion of a wall 15a of an inner peripheral surface of the device case 1a facing the two sides of the display unit 4a. As a result, in the lateral direction (X direction) and the depth direction (Y direction) in Fig. 12, the display unit 4a is pressed against and fixed to the wall 15 of the inner peripheral surface of the opposing device case 1 by the buffer member 8f and the buffer member 8g disposed between the adjacent inner peripheral surfaces of the device case 1 and the adjacent outer peripheral surfaces of the corresponding display unit 4a.

In a case where the external shapes of the device case 1a and the display unit 4a are both rectangular or the like as described above, the display unit 4 is also disposed on the upper surface of the shield member 7 provided on the circuit board 6 with the buffer member 8 (in Fig. 12, the buffer members 8a and 8b) interposed therebetween. Then, the buffer members 8a and 8b are also preferably disposed at such positions on the outer peripheral edge of the shield member 7 as to avoid the central portion of the display unit 4 disposed to overlap the circuit board 6 and be substantially symmetrical to each other about the in-plane center of the circuit board 6.

### [Operation]

As described above, in the present embodiment, in a case where the display unit 4 as a display is held in the device case 1 or the like, the display unit 4 is disposed below the windshield member 3 in the device case 1. The shield member 7 is disposed on the surface of the circuit board 6 facing the display unit 4, the buffer member 8 is disposed on the upper surface of the shield member 7, and then the circuit board 6 is disposed in the device case 1 from a back surface side of the display unit 4 (that is, a back lid member side). As a result, the display unit 4 is pushed up from the back surface side and fixed at a predetermined position.

In the present embodiment, by interposing the buffer member 8 between the shield member 7 and the display unit 4, the display unit 4 is held at a predetermined position by the anti-slip effect of the buffer member 8, and is less likely to move or be detached. When an impact is applied to the watch 100 from the outside, the buffer member 8 absorbs the impact, and the display unit 4 can be prevented from being damaged.

As illustrated in Fig. 1, if the buffer member 8 interposed between the shield member 7 and the display unit 4 is disposed on the outer peripheral side of the display unit 4 while avoiding the central portion in an in-plane direction of the display unit 4, it is possible to prevent a large pressure from being applied to the central portion of the liquid crystal display panel 41 of the display unit 4 weak to the pressure. The shield member 7 can also be prevented from being deformed and the like due to the impact absorbed by the buffer member 8, and can also avoid contact with the internal circuit element 61, short circuit, and the like.

By arranging the plurality of buffer members 8 (in the present embodiment, two buffer members 8a and 8b) at or near symmetrical positions about the central portion of the display unit 4, even when an external force is applied to the watch 100, a pressure or an impact can be uniformly dispersed, and the display unit 4 can be more reliably protected from damage and the like.

According to the module (a holding structure of the display) of the present embodiment, it is not necessary to fix the display unit 4 by adhesion, screwing, or the like, which contributes to reduction in the number of components and assembly man-hours. In addition, even when a defect occurs in the display unit 4, it is sufficient to repair or replace only the display unit 4, and it is possible to easily cope with the defect.

Since the display unit 4 is disposed above, the shield member 7 is not detached upward, and the shield member 7 can be stably disposed on the circuit board 6 without being fixed by soldering or the like.

### [Effects]

As described above, the module (a holding structure of the display unit) according to the present embodiment includes the display unit 4 as a flat plate-shaped display unit, the circuit board 6 that is disposed below the display unit 4 to overlap the display unit 4 and is equipped with the shield member 7 that covers at least a part of the circuit element 61 on a surface facing the display unit, and the buffer member 8 that is disposed on the upper surface (on the upper surface portion 71) of the shield member 7 and abuts on the lower surface of the display unit 4.

As a result, only by arranging the display unit 4 on the shield member 7, the display unit 4 is held at a predetermined position, and the display unit 4 is placed with the buffer member 8 interposed therebetween. Therefore, the display unit 4 has excellent durability against an external impact and the like. Since the display unit 4 is disposed above, the shield member is not detached upward, and can be stably disposed on the circuit board 6 without being fixed by soldering or the like.

In this manner, in the present embodiment, the display unit 4 and the shield member 7 are merely disposed in an overlapping manner, and are not required to be fixed by adhesion, screwing, or the like. Therefore, the display unit 4 and the shield member 7 can be easily removed even after being assembled in the device case 1 or the like. As a result, in a case where a defect occurs in the display unit 4 or in a case where a defect occurs in the circuit element under the shield member 7, only a defective portion can be removed without damaging the device itself, and the portion can be repaired, replaced, or the like. Therefore, in a case where there is a defect in a component such as the display unit 4, replacement in a minimum range is sufficient, and the use of the device (watch 100) can be continued for a long time without waste.

Furthermore, any electronic device that performs display is usually provided with the display unit 4. It is therefore not necessary to additionally provide a component for fixing, and there is also an effect of cost reduction due to reduction in the number of components and assembly man-hours, and the like.

In the present embodiment, the buffer member 8 is disposed on the outer peripheral side of the display unit 4 as a display.

When pressure is applied to the central portion in the in-plane direction of the display unit 4 including the liquid crystal display panel 41 and the like, a liquid crystal portion could be damaged. In this regard, as in the present embodiment, by arranging the buffer member 8 interposed between the display unit 4 and the shield member 7 on the outer peripheral side of the display unit 4, it is possible to avoid pressure from being applied to the central portion of the liquid crystal display panel 41 or the like of the display unit 4 and to prevent a defect from occurring in the display unit 4.

In the present embodiment, the buffer member 8 is in surface contact with the lower surface of the display unit 4 as a display and the upper surface of the shield member 7.

In this manner, by bringing the display unit 4 and the shield member 7 into contact with each other not at a point but on a surface, it is possible to disperse the pressure and prevent the pressure from being strongly applied only to a part.

Therefore, the display unit 4 is less likely to be damaged. In order to prevent the shield member 7 from being recessed or deformed, it is possible to protect various circuit elements 61 below the shield member 7, and it is possible to prevent a situation in which the shield member 7 as a metal component is bent, comes into contact with the circuit element 61, and is short-circuited.

In the present embodiment, the plurality of buffer member 8 is disposed at or near symmetrical positions while avoiding the central portion of the display unit 4 as a display.

As described above, when pressure is applied to the central portion in the in-plane direction of the display unit 4 including the liquid crystal display panel 41 and the like, the liquid crystal portion could be damaged. In this regard, by arranging the plurality of buffer members 8 at symmetrical positions or the like while avoiding the central portion, it is possible to effectively disperse a force even when pressure is applied and to avoid a situation in which the force is concentrated on one point.

Accordingly, damage to the liquid crystal display panel 41 and the like of the display unit 4, deformation of the shield member, and the like can be more reliably avoided.

In the present embodiment, the shield member 7 is held by the board clip 62 as a holder fixed onto the circuit board 6.

In a case where the shield member 7 is directly soldered to the circuit board 6, a space for soldering is required to be secured, and a mounting area on the board is reduced. In this regard, the reduction in the mounting area can be suppressed by holding the shield member 7 by the board clip 62.

If the shield member 7 is soldered to the circuit board 6**,** the circuit board 6 needs to be removed for an access to the circuit element 61 covered with the shield member 7. On the other hand, in the present embodiment, the shield member 7 is merely held by the board clip 62**.** Therefore, even after the shield member 7 is assembled, if a defect or the like occurs, the shield member 7 can be easily removed for an access to the circuit element 61, and only a necessary portion can be repaired or replaced. Accordingly, it is possible to save time and cost for replacing the entire circuit board 6.

In a case where the plurality of shield members 7 is provided, the plurality of buffer members 8 is also provided corresponding to the plurality of shield members 7.

As a result, the display unit 4 can be stably received, and damage to the liquid crystal display panel 41 and the like of the display unit 4, deformation of the shield member, and the like can be effectively prevented.

In a case where the module (holding structure that holds the display such as the display unit 4) according to the present embodiment is applied to electronic devices such as various watches (electronic watches) 100, the display such as the display unit 4 is not required to be fixed to the device case 1, the windshield member 3, and the like by adhesion or the like.

Therefore, when a defect occurs in the display unit 4, only the display unit 4 can be repaired or replaced, and a repair cost can be reduced more than when other members such as the device case 1 and the windshield member 3 are replaced together.

In a case where the display such as the display unit 4 is fixed to the device case 1 or the like by screwing, a space for screwing is required, and an empty space for a screw head needs to be secured after the fixing. Therefore, a mounting area and a mounting capacity in the device case 1 are reduced. In this regard, in a case where the display such as the display unit 4 is held on the shield member 7 with the buffer member 8 interposed therebetween as in the present embodiment, components and spaces for fixing the display unit 4 are not required to be secured, the cost can be reduced, the weight of the entire device can be reduced, and a large mounting area can be secured. Since a large mounting area can be secured, the circuit board 6 itself can be downsized, which also contributes to miniaturization of the entire electronic device such as the watch 100.

Although the embodiment of the present invention has been described above, the present invention is not limited to the embodiment, and it goes without saying that various modifications can be made without departing from the gist of the present invention.

For example, in the present embodiment, a case where the electronic watch is the watch 100 has been exemplified, and a case where the holding structure that holds the display such as the display unit 4 is mounted on the watch 100 has been exemplified. However, the device to which the holding structure that holds the display can be applied is not limited to these cases.

For example, the present invention can be widely applied to wearable devices such as various smartwatches and sports watches, and electronic devices that display various data, such as a heart rate meter and a blood pressure meter that display biological information such as heart rate and blood flow information, and a device that displays environmental information such as temperature and atmospheric pressure, in addition to time.

Although some embodiments of the present invention have been described above, the scope of the present invention is not limited to the above-described embodiments, and includes the scope of the invention described in the claims and the equivalent scope thereof.

### INDUSTRIAL APPLICABILITY

The present invention can stably hold the display inside the device without adhesively fixing the display.

### REFERENCE SIGNS LIST

- 1: Device case
- 3: Windshield member
- 4: Display unit (display)
- 41: Liquid crystal display panel
- 42: Light guide plate
- 44: Reflection plate (reflection member)
- 50: Coil spring
- 6: Circuit board
- 61: Circuit element
- 62: Board clip (holder)
- 7: Shield member
- 71: Upper surface portion
- 72: Side surface portion
- 8: Buffer member
- 100: Watch (electronic watch and electronic device)

## Claims

1. A module comprising:
a display having a flat plate shape;
a circuit board disposed below the display to overlap the display, and equipped with a shield member that covers a circuit element on a surface facing the display; and
a buffer member that is disposed on an upper surface of the shield member and abuts on a lower surface of the display.

2. The module according to claim 1, wherein
the buffer member is disposed on an outer peripheral side of the display.

3. The module according to claim 1, wherein
the buffer member is in surface contact with the lower surface of the display and the upper surface of the shield member.

4. The module according to claim 1, wherein
a plurality of the buffer members is disposed at or near symmetrical positions while avoiding a central portion of the display.

5. The module according to claim 1, wherein
the shield member is held by a holder fixed onto the circuit board.

6. The module according to claim 1, wherein
a plurality of the shield members is provided, and
the buffer member is provided corresponding to each of the plurality of shield members.

7. An electronic device comprising:
the module according to any one of claims 1 to 6; and
a device case that accommodates the display and the circuit board having the shield member.

8. The electronic device according to claim 7, wherein
the display and the buffer member are fixed by being sandwiched between the device case and the circuit board having the shield member.

9. The electronic device according to claim 7, wherein
the buffer member is disposed between an inner peripheral surface of the device case and an outer peripheral surface of the display in plan view.
